# EUROPEAN PATENT SPECIFICATION

(11) **EP 2 133 913 B1**
(45) Date of publication and mention of the grant of the patent: **29.05.2013**
(21) Application number: 08704008.5
(22) Date of filing: 28.01.2008
(51) Int. Cl.: H01L 23/36, C09K 5/08, H01L 23/373, H05K 7/20, H01L 23/34

(54) **HEAT TRANSFER SHEET AND RADIATOR STRUCTURE**
WÄRMETRANSFERFOLIE UND RADIATORSTRUKTUR
FEUILLE DE TRANSFERT DE CHALEUR ET STRUCTURE DE RADIATEUR

(30) Priority: 30.03.2007 JP 2007095528
(43) Date of publication of application: 16.12.2009
(73) Proprietor: Sumitomo Bakelite Company, Limited, Tokyo 140-0002 (JP); Toyota Tsusho Corporation, Aichi 450-8575 (JP); TOYOTA JIDOSHA KABUSHIKI KAISHA, Toyota-shi, Aichi-ken, 471-8571 (JP)
(72) Inventor: MURATA, Takashi, Toyota-shi Aichi 471-8571 (JP); NAKAMURA, Yoshiyuki, Toyota-shi Aichi 471-8571 (JP); TAKAHASHI, Izumi, Toyota-shi Aichi 471-8571 (JP); SOH, Hatsuhiro, Aichi 450-8575 (JP); SHIMIZU, Kazumoto, Aichi 450-8575 (JP); NII, Yoshihide, Aichi 450-8575 (JP); ITO, Shinichiro, Tokyo 140-0002 (JP); KAWAGUCHI, Hitoshi, Tokyo 140-0002 (JP); SUGINO, Mitsuo, Tokyo 140-0002 (JP)
(74) Representative: Solf, Alexander
(86) International application number: PCT/JP2008/051199
(87) International publication number: WO 2008/126448

(56) References cited:
- EP-A1- 0 852 398
- DE-A1- 3 820 736
- JP-A- 05 259 667
- JP-A- 2003 347 489
- JP-A- 2004 253 703
- US-A1- 2006 192 253
- CAMPO W A ET AL: "CHIP COOLING" IBM TECHNICAL DISCLOSURE BULLETIN, INTERNATIONAL BUSINESS MACHINES CORP. (THORNWOOD), US, vol. 17, no. 2, 1 July 1974 (1974-07-01), page 392, XP002057017 ISSN: 0018-8689

## Description

### FIELD OF THE INVENTION

The present invention relates to a heat transfer sheet being adapted to be used by being provided between an object from which heat is to be dissipated and a dissipation member for transferring the heat between the object and the dissipation member, and a heat dissipation structure in which the heat transfer sheet is used.

### BACKGROUND

In the past, for objects from which heat is to be dissipated (e.g., semiconductor parts such as a transistor, a diode and an IC and electronic parts such as various kinds of heaters and a temperature sensor), a sheet having high thermal conductivity has been used as a heat dissipation/transfer spacer (see, for example, patent document 1: Japanese Patent Application Laid-open No. 2006-278476).

As disclosed in the patent document 1, such a sheet is formed from a resin composition containing a resin and a filler having thermal conductivity. By providing the sheet between a radiation fin (heat dissipation fin) and the object described above, heat can be efficiently transferred from the object to the radiation fin. This makes it possible to prevent the object from being overheated.

However, the sheet disclosed in the patent document 1 has constant thermal conductivity in a thickness direction thereof without taking temperature changes in the object into account. Therefore, if the object is used in an environment of a very low temperature, it is supercooled. As a result, there is a case that the object cannot sufficiently exhibit its performance depending on the kind thereof.

In Campo, W.A. et al: "Chip cooling", IBM Technical Disclosure Bulletin, International Business Machines Corp. (Thornwood), US, vol. 17, no. 2, 1 July 1974, page 392, XP-002057017, ISSN: 0018-8689 a bimetallic heat conduction device for improving the thermal performance of an integrated circuit chip package is disclosed, comprising a bimetallic stripper foil. The said stripper foil comprises two sheets of different metals which have different thermal expansion coefficients and which are fastened together, wherein the bimetallic stripper foil is attached with one end along one inner edge to the underside of the module cover so that its other end is located in form of a free end above the chip. The device is arranged in such a way, that when the chip is powered heat flows to the metal foil by way of the substrate and module cover, wherein in normal operating temperature range the free end of the foil does not contact the chip, whereas at (or near) some predetermined critical temperature, which is determined by various characteristics of the metals used in the foil, the free end of the foil approaches the chip until a contact is made, whereby a conduction heat path is introduced from the top of the chip to the module by way of the foil which leads to a substantial reduction of the chip temperature and the chip-to-air thermal resistance.

US 2006/0192253 A1 discloses a heat transfer sheet comprising a heat transfer layer with first and second portions having different thermal expansion coefficients.

### SUMMARY OF THE INVENTION

It is therefore an object of the present invention to provide a heat transfer sheet being capable of maintaining a temperature of an object from which heat is to be dissipated within a predetermined temperature range by preventing both supercooling and overheating of the object even in the case where the object is used in an environment of a wide temperature range including a low temperature and a high temperature, and a heat dissipation structure in which the heat transfer sheet is used.

In order to achieve the above object, the heat transfer sheet of the present invention is adapted to be used by being provided between an object from which heat is to be dissipated and a dissipation member for transferring the heat between the object and the dissipation member. The heat transfer sheet comprises a heat transfer layer having a first portion and a second portion provided in a position different from the first portion in a planar view of the heat transfer layer, the second portion being capable of expanding and contracting in a thickness direction of the heat transfer layer at an expansion ratio larger than that of the first portion depending on temperature changes in the object. In a state that the heat transfer sheet is used, in the case where a temperature of the heat transfer layer is a predetermined temperature or lower, thermal conductivity between the object and the dissipation member is lowered due to creation of a gap between the second portion and the obj ect and/or the dissipation member, whereas in the case where the temperature of the heat transfer layer is a predetermined temperature or higher, the thermal conductivity between the object and the dissipation member is increased due to substantial elimination of the gap.

According to such a heat transfer sheet of the present invention, the heat transfer layer can change the thermal conductivity in the thickness direction thereof depending on the temperature changes in the object. This makes it possible to maintain a temperature of the object within a predetermined temperature range by preventing both supercooling and overheating of the object even in the case where the object is used in an environment of a wide temperature range including a low temperature and a high temperature.

In the above heat transfer sheet, it is preferred that a thermal expansion coefficient of the second portion in the thickness direction of the heat transfer layer is larger than that of the first portion, and a heat transfer rate of the second portion in the thickness direction of the heat transfer layer is higher than that of the first portion.

This makes it possible to change the thermal conductivity of the heat transfer sheet in the thickness direction thereof largely depending on the temperature changes in the object.

In the above heat transfer sheet, it is preferred that one of the first and second portions has a plurality of portions arranged so as to be separated from each other in the planar view of the heat transfer layer, and the other portion is provided so as to be embedded between the separated plurality of portions.

By arranging or providing the first and second portions in this way, it is possible for the separated plurality of portions to easily expand and contract depending on the temperature changes in the object without providing spaces between the separated plurality of portions and the other portion.

In the above heat transfer sheet, it is preferred that the separated portions of the first or second portion are arranged so as to be uniformly dispersed within the heat transfer layer in the planar view thereof.

This makes it possible to uniformize rigidity and the thermal conductivity of the heat transfer sheet in the thickness direction thereof all over the heat transfer sheet (in the planar direction of the heat transfer sheet).

In the above heat transfer sheet, it is preferred that the separated portions of the first or second portion are regularly arranged in a tetragonal lattice in the planar view of the heat transfer layer.

This makes it possible to impart required mechanical strength to the heat transfer sheet, and to increase an occupation ratio of the separated portions of the first or second portion with respect to the whole heat transfer sheet.

In the above heat transfer sheet, it is preferred that the second portion has the plurality of separated portions,and the first portion is provided so as to be embedded between the separated portions of the second portion.

This makes it possible to impart necessary mechanical strength to the first portion, and to impart excellent thermal conductivity to the separated portions of the second portion by increasing an occupation ratio of the separated portions of the second portion within the heat transfer layer.

In the above heat transfer sheet, it is preferred that each of the separated portions of the second portion has a columnar structure extending along the thickness direction of the heat transfer layer.

This makes it possible for the separated portions of the second portion to easily expand and contract depending on the temperature changes in the object without providing spaces between the separated portions of the second portion and the first portion.

It is preferred that the above heat transfer sheet further comprises a support layer that supports the heat transfer layer by fixing or uniting the support layer to the second portion.

This makes it possible to especially improve the mechanical strength of the heat transfer sheet, and to efficiently transfer the heat from the support layer to the second portion of the heat transfer layer. Further, this also makes it possible to increase an amount of displacement of an end of the second portion opposite from the support layer due to the temperature changes in the object. For these reasons, it is possible to remarkably lower the thermal conductivity of the heat transfer sheet (that is, it is possible to remarkably improve thermal insulation performance of the heat transfer sheet) in the thickness direction thereof by enlarging a size of a gap created between the second portion and the object and/or the dissipation member at a low temperature.

In the above heat transfer sheet, it is preferred that a constituent material of the support layer is the same as that of the second portion.

In this case, the support layer can have excellent thermal conductivity and mechanical strength.

According to a preferred method of manufacturing of the above heat transfer sheet the first portion is formed by penetrating a resin composition containing a curable resin and an inorganic filler into a fiber base member.

This makes it impossible for the first portion to substantially expand and contract in the thickness direction of the heat transfer layer depending on the temperature changes in the object. Further, this also makes it possible for the first portion to have relatively low thermal conductivity.

In the above method, it is preferred that the curable resin is cyanate resin.

This makes it possible to lower the thermal conductivity of the first portion. Further, in the case where the heat transfer sheet includes the support layer, it is possible to bond and fix the first portion to the support layer easily and reliably due to a bonding property and a fixing property of the curable resin itself without using a mechanical fixing means such as a screw or a pin. On the other hand, in the case where the support layer is omitted, it is also possible to bond and fix the first portion to the dissipation member and the object directly.

In the above method, it is preferred that fibers constituting the fiber base member include glass fibers.

This makes it possible to lower a thermal expansion coefficient of the glass fiber base member, thereby lowering the thermal expansion coefficient of the first portion.

In the above heat transfer sheet, it is preferred that the second portion is formed of a metal as a major component thereof.

This makes it possible to improve the thermal conductivity of the second portion.

In the above heat transfer sheet, it is preferred that the metal constituting the second portion is aluminum or an alloy containing aluminum.

This makes it possible to improve the thermal conductivity of the second portion. Further, this also makes it possible to enlarge a size of the gap created between the second portion and the object and/or the dissipation member in the thickness direction of the heat transfer layer, thereby improving thermal insulation performance of the heat transfer sheet by utilizing the gap.

In the above heat transfer sheet, it is preferred that an occupation ratio of an area of the second portion with respect to a total area of the heat transfer layer in the planar view thereof is in the range of 50 to 85%.

This makes it possible to impart a required mechanical strength to the heat transfer sheet, and to increase an occupation ratio of the second portion with respect to the whole heat transfer sheet.

Further, the heat dissipation structure of the present invention comprises an object from which heat is to be dissipated, a dissipation member, and the above heat transfer sheet, wherein the heat can be dissipated from the object by transferring the heat from the object to the dissipation member through the heat transfer sheet.

According to such a heat dissipation structure of the present invention, it is possible to maintain a temperature of the object within a predetermined temperature range by preventing both supercooling and overheating of the obj ect even in the case where the object is used in an environment of a wide temperature range including a low temperature and a high temperature.

In the above heat dissipation structure, it is preferred that the heat transfer sheet further comprises a support layer that supports the heat transfer layer by fixing or uniting the support layer to the second portion, and the heat transfer sheet is provided so that the support layer is positioned on a side of the object.

This makes it possible to uniformize rigidity and the thermal conductivity of the heat transfer sheet in the thickness direction thereof all over the heat transfer sheet (in the planar direction of the heat transfer sheet).

### BRIEF DESCRIPTION OF THE DRAWINGS

FIG. 1 is a perspective view schematically showing a structure of a preferred embodiment of a heat transfer sheet according to the present invention.
FIG. 2 is a sectional view of the heat transfer sheet shown in FIG. 1 being cut along the A-A line shown in FIG. 1.
FIG. 3 is a view for explaining working of the heat transfer sheet shown in FIG. 1.
FIG. 4 is a view for explaining a concrete example of a heat dissipation structure according to the present invention.
FIG. 5 is a perspective view showing a main part of the heat dissipation structure shown in FIG. 4.

### BEST MODE FOR CARRYING OUT THE INVENTION

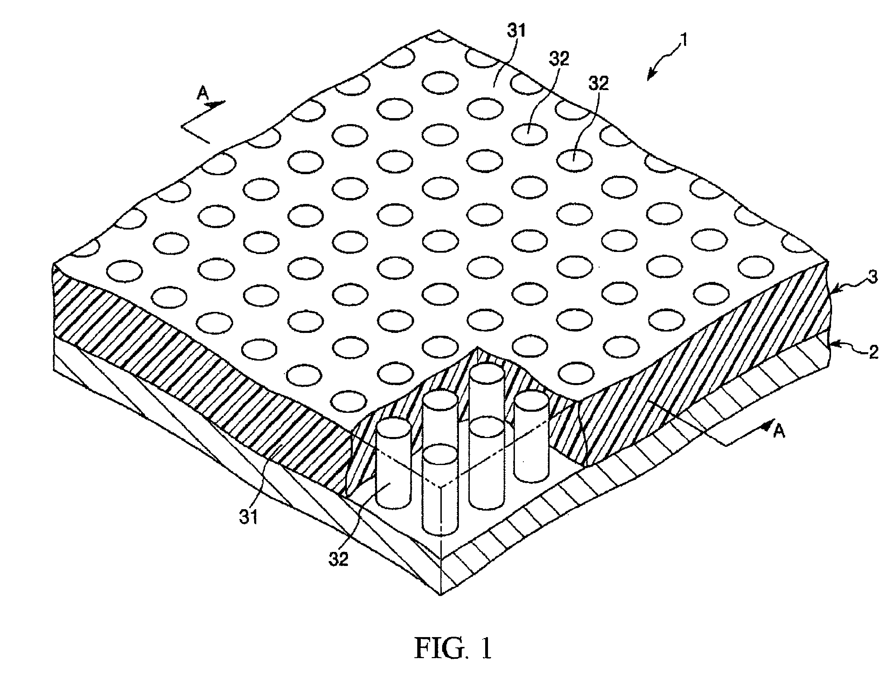

Hereinbelow, description will be made on an embodiment of a heat transfer sheet according to the present invention in detail with reference to FIGs. 1 to 5.

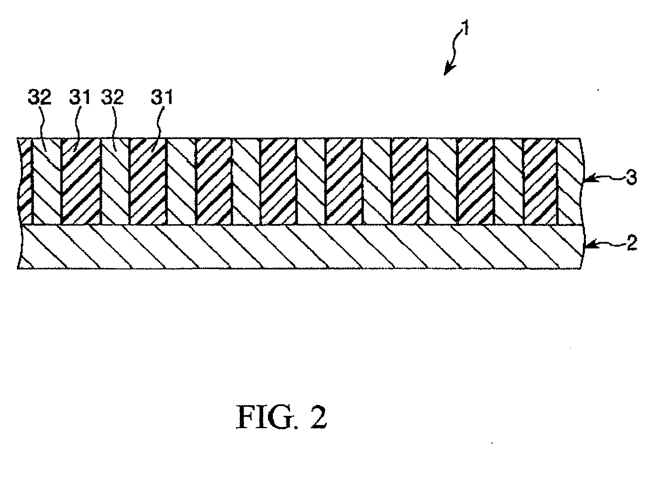

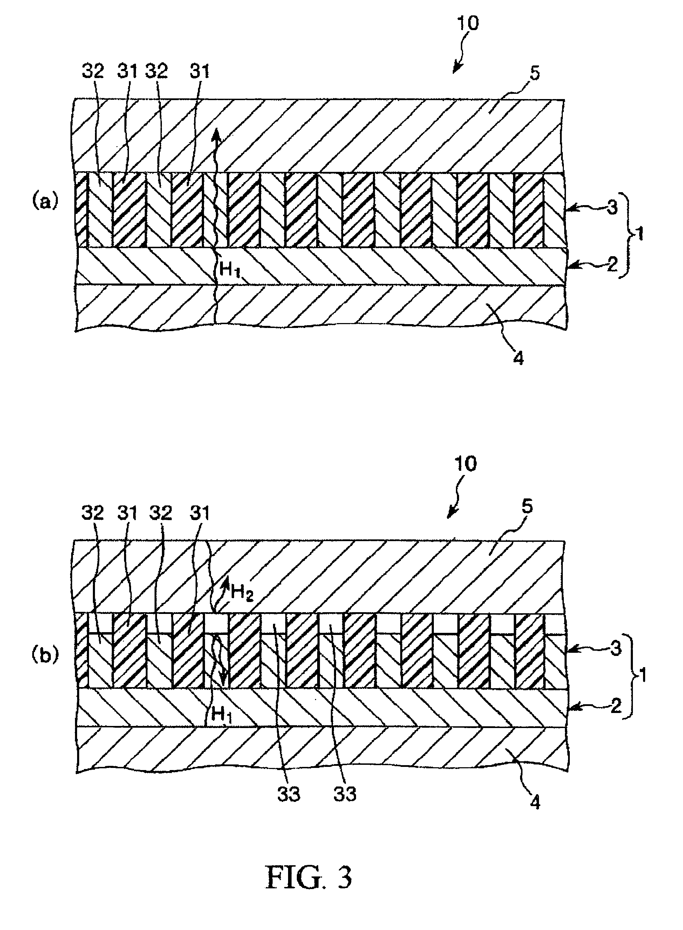

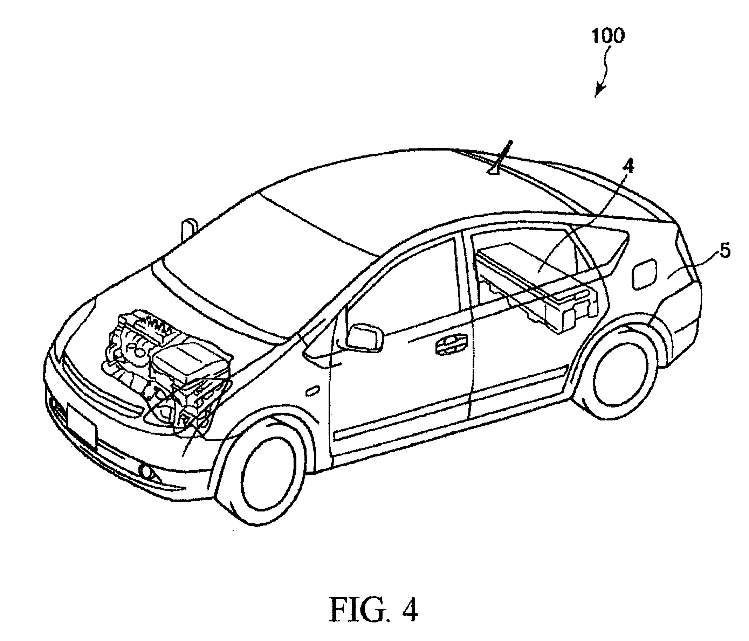

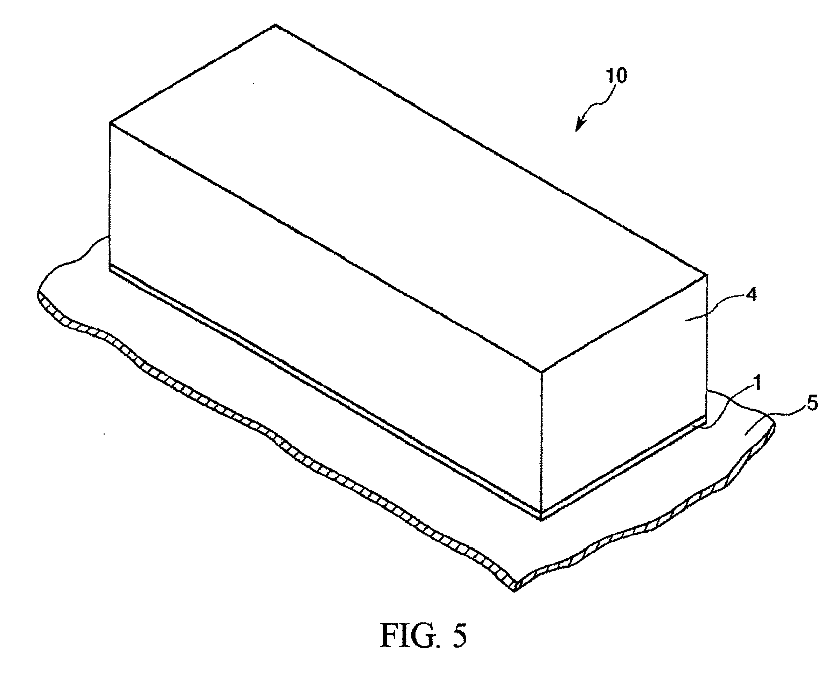

FIG. 1 is a perspective view schematically showing a structure of a preferred embodiment of the heat transfer sheet according to the present invention. FIG. 2 is a sectional view of the heat transfer sheet shown in FIG. 1 being cut along the A-A line shown in FIG. 1. FIG. 3 is a view for explaining working of the heat transfer sheet shown in FIG. 1. FIG. 4 is a view for explaining a concrete example of the heat dissipation structure according to the present invention. FIG. 5 is a perspective view showing a main part of the heat dissipation structure shown in FIG. 4.

As shown in FIGs. 1 and 2, a heat transfer sheet 1 according to the present invention is, as described below, adapted to be used by being provided between an obj ect from which heat is to be dissipated and a dissipation member for transferring the heat between the object and the dissipation member. In this regard, it is to be noted that the object and the dissipation member will be described in detail below.

Such a heat transfer sheet 1 includes a support layer 2, and a heat transfer layer 3 which is supported by the support layer 2 by being bonded (fixed) thereto and can change thermal conductivity in a thickness direction thereof depending on temperature changes in the object.

Although the temperature changes in the object occur due to changes of outside air temperature or heating of the object itself, the heat transfer layer 3 of such a heat transfer sheet 1 can change the thermal conductivity in the thickness direction thereof depending on the temperature changes in the object. This makes it possible to prevent supercooling and overheating of the object. As a result, it is possible to maintain a temperature of the object within a predetermined range.

Hereinblow, parts constituting such a heat transfer sheet 1 will be described one after another.

The support layer 2 has a function of supporting the heat transfer layer 3. Further, as described below, the support layer 2 also has a function of receiving heat from the object and transferring the heat to the heat transfer layer 3 in a state that the heat transfer sheet 1 is used. Furthermore, the support layer 2 also has a function of uniformizing heat to be transferred to the heat transfer layer 3 by diffusing the heat received from the object and transferring through the support layer 2 in a planar direction thereof. In this way, since the support layer 2 transfers the heat while diffusing it in the planar direction thereof, it is possible to improve heat transfer efficiency of the heat transfer sheet 1. In this regard, it is to be noted that the support layer 2 may be omitted, if needed, depending on a structure of the heat transfer layer 3.

Although a constituent material of the support layer 2 is not particularly limited to a specific one as long as the support layer 2 can have the above functions, various kinds of organic materials or various kinds of inorganic materials can be used as the constituent material of the support layer 2. As the constituent material of the support layer 2, a material having excellent thermal conductivity is preferably used, and the same material as a constituent material of each second portion 32 of the heat transfer layer 3 is more preferably used.

In the case where the constituent material of the support layer 2 is the same as the constituent material of each second portion 32, the support layer 2 can have excellent thermal conductivity and mechanical strength in addition to the above functions. Further, in the case where each second portion 32 is fixed or united to the support layer 2, it is possible to especially improve mechanical strength of the heat transfer sheet 1, and to efficiently transfer heat from the support layer 2 to each second portion 32 of the heat transfer layer 3.

An average thickness of the support layer 2 is not particularly limited a specific value as long as the support layer 2 can have the above functions, but is preferably in the range of 0.01 to 5 mm, and more preferably in the range of 0.1 to 3 mm. This makes it possible to impart moderate flexibility and mechanical strength in addition to the above functions to the support layer 2, while suppressing increase of the thickness of the heat transfer sheet 1.

In contrast, if the average thickness of the support layer 2 is less than the above lower limit value, there is a case that the support layer 2 itself lacks the mechanical strength depending on the constituent material of the support layer 2. On the other hand, if the average thickness of the support layer 2 exceeds the above upper limit value, the thermal conductivity of the support layer 2 is lowered depending on the constituent material thereof. As a result, heat tends to become difficult to be transferred and dissipated from the object to the dissipation member through the heat transfer sheet 1.

The heat transfer layer 3 is supported by such a support layer 2 by being bonded to one surface (upper surface in FIGs. 1 and 2) thereof.

The heat transfer layer 3 can change the thermal conductivity in the thickness direction thereof depending on the temperature changes in the object.

As shown in FIGs. 1 and 2, such a heat transfer layer 3 includes a first portion and a second portion provided in a position different from the first portion in a planar view of the heat transfer layer 3. In this embodiment, the second portion has a plurality of portions arranged so as to be separated from each other in the planar view of the heat transfer layer 3. In this embodiment, the first portion is referred to as "first portion 31", and each of the separated portions of the second portion is referred to as "second portion 32". In other words, the first portion 31 is of a structure in which a plurality of holes each having a cylindrical shape pass through the heat transfer layer 3 in the thickness direction thereof, and each second portion 32 is provided so as to be inserted into each hole.

Especially, in this embodiment, the plurality of second portions 32 are arranged in a tetragonal lattice manner (that is, matrix manner) in the planar view of the heat transfer layer 3, and the first portion 31 is provided so as to be embedded between the second portions 32.

In such a heat transfer layer 3, in the case where a temperature of the heat transfer layer 3 is a predetermined temperature or lower, thermal conductivity between the object and the dissipation member is lowered due to creation of gaps 33 between the second portions 32 and the dissipation member (and/or the object), whereas in the case where the temperature of the heat transfer layer 3 is a predetermined temperature or higher, the thermal conductivity between the object and the dissipation member is increased due to substantial elimination of the gaps 33.

Especially, since the plurality of second portions 32 are arranged so as to be separated from each other in the planar view of the heat transfer layer 3, and the first portion 31 is provided so as to be embedded between the second portions 32, it is possible to impart necessary mechanical strength to the first portion 31, and to impart excellent thermal conductivity to the second portions 32 by increasing an occupation ratio of the second portions 32 within the heat transfer layer 3. Further, by arranging or providing the first portion 31 and the second portions 32 in this way, it is possible for the second portions 32 to easily expand and contract depending on the temperature changes in the object without providing spaces between the first portion 31 and the second portions 32. For this reason, in the case where the gaps 33 are created, it is possible to improve thermal insulation performance of the heat transfer sheet 1 (that is, it is possible to further lower the thermal conductivity of the heat transfer sheet 1) .

Hereinblow, the first portion 31 and the second portions 32 will be described in detail one after another.

### <First portion>

The first portion 31 serves as a spacer for creating the gaps 33 between the second portions 32 and the dissipation member in the case where the second portions 32 contract. Such a first portion 31 can expand and contract in the thickness direction of the heat transfer layer 3 at an expansion ratio smaller than that of each second portion 32 depending on the temperature changes in the object. Namely, a thermal expansion coefficient of the first portion 31 in the thickness direction of the heat transfer layer 3 is smaller than that of each second portion 32. In this case, since the first portion 31 substantially does not expand and contract in the thickness direction of the heat transfer layer 3 depending on the temperature changes in the object, it is possible to substantially keep a constant distance between the object and the dissipation member.

Although the thermal conductivity of the heat transfer sheet 1 can be changed due to presence or absence of the gaps 33 described above, it is preferred that the thermal expansion coefficient of the first portion 31 in the thickness direction of the heat transfer layer 3 is smaller than that of each second portion 32 as described above, and a heat transfer rate of the first portion 31 in the thickness direction of the heat transfer layer 3 is lower than that of each second portion 32. This makes it possible to change the thermal conductivity of the heat transfer sheet 1 in the thickness direction thereof at a large rate depending on the temperature changes in the object.

The thermal expansion coefficient of the first portion 31 in the thickness direction of the heat transfer layer 3 is not particularly limited to a specific value as long as it is smaller than the thermal expansion coefficient of each second portion 32 in the thickness direction of the heat transfer layer 3, but is preferably in the range of about 3 to 20 ppm.

In this regard, it is to be noted that the thermal expansion coefficient can be measured using a thermomechanical analysis (TMA) instrument based on a method described in JIS K-7197. Specifically, the thermal expansion coefficient can be measured by setting a test sample on a stage and heating at a constant temperature rise rate in a state that a constant load is applied to the test sample, detecting an expansion amount of the test sample using a differential transformer as an electric output, and then checking a relationship between a detection result and a temperature.

Further, an average thickness of the first portion 31 is not particularly limited to a specific value as long as it can have the function described above, but is preferably in the range of 1 to 5 mm, and more preferably in the range of 1 to 2 mm. This makes it possible to impart the function described above to the first portion 31, while suppressing increase of a total thickness of the heat transfer sheet 1. In this regard, it is to be noted that the thickness of the first portion 31 can be adjusted to a desired value by selecting kinds of fiber base members described below, an amount of a resin composition to be applied to the fiber base member, drying conditions and the like.

Such a first portion 31 is formed by penetrating a resin composition containing a curable resin and an inorganic filler into a fiber base member. In such a structure, the first portion 31 substantially does not expand and contract in the thickness direction of the heat transfer layer 3 depending on the temperature changes in the object, and can have relatively low thermal conductivity. Here, the resin composition may contain a curing auxiliary agent such as a curing agent or a curing accelerating agent, various kinds of additive agents, and the like, if needed.

Hereinblow, materials constituting the first portion 31 will be described one after another.

### (Curable resin)

As the curable resin contained in the resin composition constituting the first portion 31, a thermosetting resin such as urea resin, melamine resin, bismaleimide resin, polyurethane resin, benzoxazine ring-containing resin, cyanate ester resin, bisphenol S type epoxy resin, bisphenol F type epoxy resin, or copolymeric epoxy resin of bisphenol S and bisphenol F is preferably used. Among these curable resins, cyanate resin is more preferably used. By using the thermosetting resin (especially, cyanate resin), it is possible to lower the thermal expansion coefficient of the first portion 31. By forming the first portion 31 using the resin composition containing such a thermosetting resin, it is possible to bond and fix the first portion 31 to the support layer 2 easily and reliably due to a bonding property and a fixing property of the curable resin itself without using a mechanical fixing means such as a screw or a pin. Further, in the case where the support layer 2 is omitted, it is also possible to bond and fix the first portion 31 to the dissipation member and the object.

The cyanate resin can be obtained by, for example, a reaction of cyanogen halide and phenol.

Examples of the cyanate resin include novolak type cyanate resin, bisphenol type cyanate resin such as bisphenol A type cyanate resin, bisphenol E type cyanate resin or tetramethyl bisphenol F type cyanate resin, and the like. Among these cyanate resins, the novolak type cyanate resin is preferably used. By using the novolak type cyanate resin, it is possible for the cyanate resin to have a relatively increased crosslink density, thereby improving heat resistance and flame retardancy of the first portion 31. Further, even if the first portion 31 is made thinner, it is possible to impart superior rigidity to the heat transfer layer 3.

As the novolak type cyanate resin, one represented by, for example, the following formula (I) can be used.

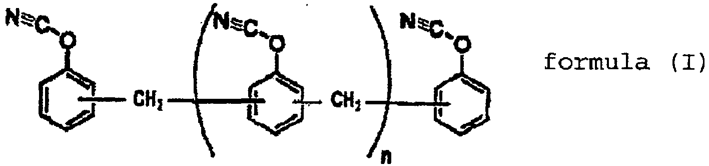

wherein "n" is any integer.

An average number of repeating units "n" of the novolak type cyanate resin represented by the above formula (I) is not particularly limited to a specific value, but is preferably in the range of 1 to 10, and more preferably in the range of 2 to 7. If the average number of repeating units "n" is less than the above lower limit value, the novolak type cyanate resin tends to be crystallized, thereby relatively lowering solubility of the novolak type cyanate resin in general purpose-solvents. As a result, there is a case that it is difficult to handle a varnish containing the resin composition (that is, a varnish for forming the first portion 31: hereinbelow, the same meaning shall apply) depending on an amount of the novolak type cyanate resin contained in the resin composition, and the like. In addition, in this case, since the heat transfer sheets 1 become tacky, there is also a case that when one heat transfer sheet 1 makes contact with another heat transfer sheet 1, the heat transfer sheets 1 adhere to each other, or the resin composition of the one heat transfer sheet 1 is transferred to unnecessary portions of the other heat transfer sheet 1. On the other hand, if the average number of repeating units "n" exceeds the above upper limit value, a melt viscosity of the resin composition becomes too high when forming the first portion 31 depending on kinds of solvents, and therefore there is a case that manufacturing efficiency (moldability) of the heat transfer sheet 1 is lowered.

A weight average molecular weight of the cyanate resin is not particularly limited to a specific value, but is preferably in the range of 500 to 4,500, and more preferably in the range of 600 to 3, 000. If the weight average molecular weight of the cyanate resin is less than the above lower limit value, since the heat transfer sheets 1 become tacky, there is a case that when one heat transfer sheet 1 makes contact with another heat transfer sheet 1, the heat transfer sheets 1 adhere to each other, or the resin composition of the one heat transfer sheet 1 is transferred to unnecessary portions of the other heat transfer sheet 1. On the other hand, if the weight average molecular weight of the cyanate resin exceeds the above upper limit value, there is a case that a reaction rate of the cyanate resin becomes too high when forming the first portion 31, thereby causing defective molding of the heat transfer sheet 1.

In this regard, it is to be noted that the weight average molecular weight of the cyanate resin can be measured using, for example, a GPC (gel permeation chromatography).

An amount of the curable resin with respect to a total weight of the resin composition is not particularly limited to a specific value, but is preferably in the range of 5 to 50 wt%, and more preferably in the range of 10 to 40 wt%. If the amount of the curable resin is less than the above lower limit value, there is a case that it becomes difficult to form the heat transfer sheet 1 depending on a viscosity and the like of the resin composition. On the other hand, if the amount of the curable resin exceeds the above upper limit value, there is a case that mechanical strength of the heat transfer sheet 1 is lowered depending on the kind of the curable resin, the weight average molecular weight of the curable resin and the like.

### (Epoxy resin)

Further, in the case where the cyanate resin (especially, novolak type cyanate resin) is used as the curable resin, epoxy resin (which contains substantially no halogen atom) is preferably used in combination with the cyanate resin.

Examples of the epoxy resin include phenol novolak type epoxy resin, bisphenol type epoxy resin, naphthalene type epoxy resin, aryl alkylene type epoxy resin, and the like. Among these epoxy resins, the aryl alkylene type epoxy resin is preferably used. By using such epoxy resin, it is possible for the first portion 31 after being cured (obtained heat transfer sheet 1) to have improved heat resistance and flame retardancy.

The aryl alkylene type epoxy resin is epoxy resin having one or more aryl alkylene groups in one repeating unit. Examples of such aryl alkylene type epoxy resin include xylylene type epoxy resin, biphenyl dimethylene type epoxy resin, and the like. Among these aryl alkylene type epoxy resins, the biphenyl dimethylene type epoxy resin is preferably used. The biphenyl dimethylene type epoxy resin can be represented by, for example, the following formula (II).

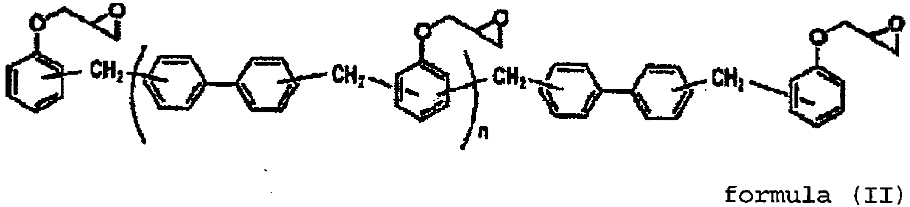

wherein "n" is any integer.

An average number of repeating units "n" of the biphenyl dimethylene type epoxy resin represented by the above formula (II) is not particularly limited to a specific value, but is preferably in the range of 1 to 10, and more preferably in the range of 2 to 5. If the average number of repeating units "n" is less than the above lower limit value, the biphenyl dimethylene type epoxy resin tends to be crystallized, thereby lowering solubility of the biphenyl dimethylene type epoxy resin in general purpose-solvents. As a result, there is a case that it becomes difficult to handle the resin composition. On the other hand, if the average number of repeating units "n" exceeds the above upper limit value, there is a case that flowability of the resin composition is lowered, thereby causing defective molding of the heat transfer sheet 1, and the like.

In the case where a combination of the epoxy resin and the cyanate resin is used as the curable resin, an amount of the epoxy resin with respect to the total weight of the resin composition is not particularly limited to a specific value, but is preferably in the range of 1 to 55 wt%, and more preferably in the range of 2 to 40 wt%. If the amount of the epoxy resin is less than the above lower limit value, there is a case that reactivity of the cyanate resin is lowered or moisture resistance of the first portion 31 obtained is lowered. On the other hand, if the amount of the epoxy resin exceeds the above upper limit value, there is a case that heat resistance of the first portion 31 is lowered depending on the kind of the epoxy resin, and the like.

A weight average molecular weight of the epoxy resin is not particularly limited to a specific value, but is preferably in the range of 300 to 20,000, and more preferably in the range of 500 to 5,000. If the weight average molecular weight of the epoxy resin is less than the above lower limit value, there is a case that the heat transfer sheet 1 becomes tacky depending on ambient temperature, and the like. On the other hand, if the weight average molecular weight of the epoxy resin exceeds the above upper limit value, there is a case that it becomes difficult to impregnate a fiber base member with the resin composition in the forming process of the first portion 31, and therefore a heat transfer sheet 1 having an uniform thickness and uniform quality cannot be obtained.

### (Phenolic resin)

Further, in the case where the cyanate resin (especially, novolak type cyanate resin) is used as the thermosetting resin, phenolic resin is preferably used in combination with the cyanate resin. In this way, in the case where the cyanate resin (especially, novolak type cyanate resin) is used in combination with the phenolic resin, it is possible to improve adhesiveness between the support layer 2 and the first portion 31 by controlling a crosslinking density of the first portion 31.

Examples of the phenolic resin include novolak type phenolic resin, resol type phenolic resin, aryl alkylene type phenolic resin, and the like. Among these phenolic resins, the aryl alkylene type phenolic resin is preferably used. By using such phenolic resin, it is possible to improve heat resistance of the first portion 31 after being subjected to a moisture absorption treatment.

Examples of the aryl alkylene type phenolic resin include xylylene type phenolic resin, biphenyl dimethylene type phenolic resin, and the like. The biphenyl dimethylene type phenolic resin can be represented by, for example, the following formula (III).

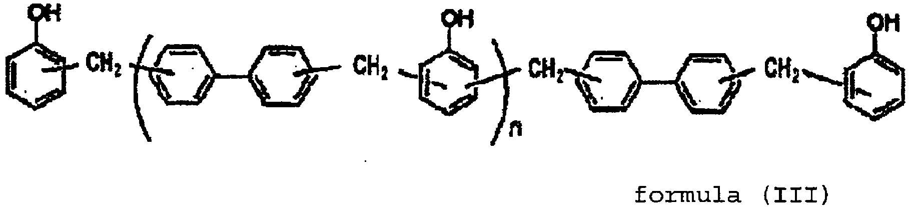

wherein "n" is any integer.

An average number of repeating units "n" of the biphenyl dimethylene type phenolic resin represented by the above formula (III) is not particularly limited to a specific value, but is preferably in the range of 1 to 12, and more preferably in the range of 2 to 8. If the average number of repeating units "n" of the biphenyl dimethylene type phenolic resin is less than the above lower limit value, there is a case that heat resistance of the first portion 31 is lowered. On the other hand, if the average number of repeating units "n" of the biphenyl dimethylene type phenolic resin exceeds the above upper limit value, there is a case that mutual solubility between the biphenyl dimethylene type phenolic resin and another resin is lowered, thereby lowering workability when forming the first portion 31.

In the case where a combination of the phenolic resin and the cyanate resin is used as the curable resin, an amount of the phenolic resin with respect to the total weight of the resin composition is not particularly limited to a specific value, but is preferably in the range of 1 to 55 wt%, and more preferably in the range of 5 to 40 wt%. If the amount of the phenolic resin is less than the above lower limit value, there is a case that heat resistance of the first portion 31 is lowered. On the other hand, if the amount of the phenolic resin exceeds the above upper limit value, a thermal expansion coefficient of the first portion 31 tends to become large.

A weight average molecular weight of the phenolic resin is not particularly limited to a specific value, but is preferably in the range of 400 to 18,000, and more preferably in the range of 500 to 15, 000. If the weight average molecular weight of the phenolic resin is less than the above lower limit value, there is a case that the heat transfer sheet 1 becomes tacky. On the other hand, if the weight average molecular weight of the phenolic resin exceeds the above upper limit value, there is a case that it becomes difficult to impregnate the fiber base member with the resin composition in the forming process of the first portion 31, and to thereby obtain a heat transfer sheet 1 having an uniform thickness and uniform quality.

### (Another curable resin)

The curable resin constituting the resin composition may contain another thermosetting resin instead of or in addition to the curable resins described above. Examples of such a thermosetting resin include: phenolic resin such as novolak type phenolic resin (e.g. , phenol novolak resin, cresol novolak resin, bisphenol A novolak resin), or resol type phenolic resin (e.g., non-modified resol phenolic resin, oil-modified resol phenolic resin modified with oil such as wood oil, linseed oil or walnut oil) ; epoxy resin such as bisphenol type epoxy resin (e.g., bisphenol A epoxy resin, bisphenol F epoxy resin), novolak type epoxy resin (e.g., novolak epoxy resin, cresol novolak epoxy resin), or biphenyl type epoxy resin; unsaturated polyester resin; diallyl phthalate resin; silicone resin; and the like. In this case, the resin composition contains a curing auxiliary agent such as a curing agent or a curing accelerating agent.

Furthermore, as the curable resin, UV curable resin, anaerobic curable resin or the like may be used instead of the thermosetting resin or in addition to the thermosetting resin.

### (Curing auxiliary agent)

Examples of the curing auxiliary agent (e.g., the curing agent, the curing accelerating agent) include: tertiary amine such as triethyl amine, tributyl amine, or diazabicyclo[2,2,2]octane; an imidazole compound such as 2-ethyl-4-ethyl imidazole, 2-phenyl-4-methyl imidazole, 2-phenyl-4-methyl-5-hydroxymethyl imidazole, 2-phenyl-4,5-dihydroxymethyl imidazole, 2,4-diamino-6-[2'-methyl imidazolyl-(1')]-ethyl-s-triazine, 2,4-diamino-6-(2'-undecyl imidazolyl)-ethyl-s-triazine, 2,4-diamino-6-[2'-ethyl-4-methyl imidazolyl-(1')]-ethyl-s-triazine, or 1-benzyl-2-phenyl imidazole; and the like.

Among these curing auxiliary agents, an imidazole compound having two or more functional groups each selected from an aliphatic hydrocarbon group, an aromatic hydrocarbon group, a hydroxyalkyl group, and a cyanoalkyl group is preferably used, and the 2-phenyl-4,5-dihydroxymethyl imidazole is more preferably used. By using such an imidazole compound, it is possible to improve heat resistance of the first portion 31 and to impart low thermal expansivity (that is, a property such that an expansion coefficient caused by heat is low) and a low water-absorbing property to the first portion 31.

Further, another curing auxiliary agent can be used instead of the curing auxiliary agents described above. Examples of such a curing auxiliary agent include: organometallic salt such as zinc naphthenate, cobalt naphthenate, tin octylate, cobalt octylate, cobalt (II) bisacetylacetonate, or cobalt (III) triacetylacetonate; a phenol compound such as phenol, bisphenol A, or nonylphenol; organic acid such as acetic acid, benzoic acid, salicylic acid, or paratoluenesulfonic acid; and the like.

In the case where the curing auxiliary agent is used, an amount of the curing auxiliary agent with respect to the total weight of the resin composition is not particularly limited to a specific value, but is preferably in the range of 0.01 to 3 wt%, and more preferably in the range of 0.1 to 1 wt%. If the amount of the curing auxiliary agent is less than the above lower limit value, there is a case that an effect of accelerating curing of the curable resin (first portion 31) cannot be sufficiently obtained depending on the kind of the curing auxiliary agent, and the like. On the other hand, if the amount of the curing auxiliary agent exceeds the above upper limit value, there is a case that storage stability of the heat transfer sheet 1 is lowered.

### (Inorganic filler)

Further, examples of the inorganic filler contained in the resin composition include talc, alumina, glass, silica, mica, aluminum hydroxide, magnesium hydroxide, and the like. Since the resin composition contains such an inorganic filler, even if the first portion 31 is made thinner, it is possible to improve mechanical strength (especially, rigidity) of the first portion 31 and to significantly lower the thermal expansion coefficient of the first portion 31.

Among these inorganic fillers, the silica is preferably used. From the viewpoint of excellent low thermal expansivity, molten silica (especially, spherical molten silica) is preferably used. The inorganic filler (that is, the particles thereof) may have a crushed shape or a spherical shape, but a shape of the inorganic filler is appropriately selected according to its purpose of use. For example, in order to impregnate the fiber base member with the resin composition reliably, it is preferred that a melt viscosity of the resin composition is lowered. In this case, spherical silica is preferably used as the inorganic filler.

An average particle size of the inorganic filler is not particularly limited to a specific value, but is preferably in the range of 0.01 to 5.0 *µ*m, and more preferably in the range of 0.2 to 2.0 *µ*m. If the average particle size of the inorganic filler is less than the above lower limit value, there is a case that the viscosity of the varnish containing the resin composition becomes high depending on an amount of the inorganic filler contained in the resin composition, and the like, thereby affecting workability during manufacture of the heat transfer sheet 1. On the other hand, if the average particle size of the inorganic filler exceeds the above upper limit value, there is a case that a phenomenon such as sedimentation of the inorganic filler in the varnish occurs. In contrast, by setting the average particle size of the inorganic filler to a value within the above range, it is possible to exhibit the effects obtained by using the inorganic filler in a fine balance.

Especially, in the case where the spherical silica (especially, spherical molten silica) is used as the inorganic filler. An average particle size of the spherical silica is preferably 5. 0 *µ*m or less, more preferably in the range of 0.01 to 2.0 *µ*m, and even more preferably in the range of 0.1 to 0.5 *µ*m. By using such spherical silica as the inorganic filler, it is possible to improve a filling factor (packing density) of the inorganic filler within the first portion 31.

In this regard, it is to be noted that the average particle size of the inorganic filler can be measured by, for example, a particle size distribution analyzer ("LA-500" produced by HORIBA).

An amount of the inorganic filler with respect to the total weight of the resin composition is not particularly limited to a specific value, but is preferably in the range of 20 to 70 wt%, and more preferably in the range of 30 to 60 wt%. If the amount of the inorganic filler is less than the above lower limit value, there is a case that an effect obtained by using the inorganic filler, which imparts low thermal expansivity and a low water-absorbing property to the first portion 31, is lowered depending on the kind of the inorganic filler, and the like. On the other hand, if the amount of the inorganic filler exceeds the above upper limit value, there is a case that flowability of the resin composition is lowered so that moldability of the first portion 31 (heat transfer sheet 1) is lowered. In contrast, by setting the amount of the inorganic filler to a value within the above range, it is possible to exhibit the effects obtained by using the inorganic filler in a fine balance.

### (Another component contained in resin composition)

Further, the resin composition may further contain another component in addition to the components described above. Examples of such a component include phenoxy resin, polyvinyl alcohol-based resin, a coupling agent and the like. In the case where the resin composition contains such components, it is possible to improve adhesiveness between the first portion 31 and the support layer 2.

Examples of the phenoxy resin include phenoxy resin having bisphenol chemical structures, phenoxy resin having naphthalene chemical structures, phenoxy resin having biphenyl chemical structures, and the like. Alternatively, phenoxy resin having two or more kinds of these chemical structures may also be used.

Among these phenoxy resins, phenoxy resin having biphenyl chemical structures and bisphenol S chemical structures is preferably used. Such phenoxy resin has a high glass transition temperature due to rigidity resulting from the biphenyl chemical structures and has improved adhesiveness between the first portion 31 and the support layer 2 resulting from the bisphenol S chemical structures.

Further, phenoxy resin having bisphenol A chemical structures and bisphenol F chemical structures is also preferably used. By using such phenoxy resin, it is possible to further improve the adhesiveness between the first portion 31 and the support layer 2.

In this case, it is preferred that the phenoxy resin having biphenyl chemical structures and bisphenol S chemical structures and the phenoxy resin having bisphenol A chemical structures and bisphenol F chemical structures are used in combination. By doing so, it is possible for the heat transfer sheet 1 to exhibit the effects described above more remarkably.

Further, in this case, a ratio of a weight (1) of the phenoxy resin having bisphenol A chemical structures and bisphenol F chemical structures with respect to a weight (2) of the phenoxy resin having biphenyl chemical structures and bisphenol S chemical structures is not particularly limited to a specific value, but the ratio (1): (2) can be set to a value in the range of, for example, 2:8 to 9:1.

A weight average molecular weight of the phenoxy resin is not particularly limited to a specific value, but is preferably in the range of 5, 000 to 70,000, and more preferably in the range of 10,000 to 60,000. If the weight average molecular weight of the phenoxy resin is less than the above lower limit value, there is a case that it is impossible to sufficiently obtain an effect of improving the adhesiveness between the first portion 31 and the support layer 2 depending on the kind of the phenoxy resin, and the like. On the other hand, if the weight average molecular weight of the phenoxy resin exceeds the above upper limit value, there is a case that solubility of the phenoxy resin is lowered depending on the kind of a solvent used for preparing the resin varnish, and the like in the forming process of the first portion 31. In contrast, by setting the weight average molecular weight of the phenoxy resin to a value within the above range, it is possible to exhibit the effects obtained by using the phenoxy resin in a fine balance.

In the case where the phenoxy resin is used, an amount of the phenoxy resin with respect to the total weight of the resin composition is not particularly limited to a specific value, but is preferably in the range of 1 to 40 wt%, and more preferably in the range of 5 to 30 wt%. If the amount of the phenoxy resin is less than the above lower limit value, there is a case that it is impossible to sufficiently obtain an effect of improving the adhesiveness between the first portion 31 and the support layer 2 depending on the kind of the phenoxy resin, and the like. On the other hand, if the amount of the phenoxy resin exceeds the above upper limit value, the amount of the curable resin contained in the resin composition becomes relatively small. Therefore, in the case where the cyanate resin is used as the curable resin, there is a case that the thermal expansion coefficient of the first portion 31 tends to become large depending on the kind of the cyanate resin, the kind of the phenoxy resin, and the like. In contrast, by setting the amount of the phenoxy resin to a value within the above range, it is possible to exhibit the effects obtained by using the phenoxy resin in a fine balance.

The coupling agent has a function of improving wettability of an interface between the curable resin and the inorganic filler. Therefore, by adding such a coupling agent to the resin composition, it is possible to uniformly fix the curable resin and the inorganic filler to the fiber base member. This makes it possible to improve heat resistance of the first portion 31, especially heat resistance after moisture absorption of the first portion 31.

Examples of the coupling agent include an epoxy silane coupling agent, a titanate-based coupling agent, an amino silane coupling agent, a silicone oil type coupling agent, and the like. One or more coupling agents selected from the above coupling agents are preferably used. By using such a coupling agent, it is possible to particularly improve the wettability of the interface between the curable resin and the inorganic filler, thereby further improving the heat resistance of the first portion 31.

In the case where the coupling agent is used, an amount of the coupling agent contained in the resin composition is not particularly limited to a specific vale, but is preferably in the range of 0.05 to 3 parts by weight, and more preferably in the range of 0.1 to 2 parts by weight with respect to 100 parts by weight of the inorganic filler. If the amount of the coupling agent is less than the above lower limit value, there is a case that it is impossible to sufficiently cover a surface of the inorganic filler with the coupling agent depending on the kind of the coupling agent, the kind, shape or size of the inorganic filler, and the like, thereby lowering the effect of improving the heat resistance of the first portion 31. On the other hand, if the amount of the coupling agent exceeds the above upper limit value, there is a case that the coupling agent affects a curing reaction of the curable resin depending on the kind of the curable resin, and the like, thereby lowering bending strength and the like of the first portion 31 after being cured (obtained heat transfer sheet 1). In contrast, by setting the amount of the coupling agent to a value within the above range, it is possible to exhibit the effects obtained by using the coupling agent in a fine balance.

If necessary, the resin composition may further contain additives such as an antifoaming agent, a leveling agent, a pigment and an antioxidant, in addition to the components described above.

### (Fiber base member)

Examples of the fiber base member into which the resin composition as described above is impregnated include: an inorganic fiber base member such as a glass fiber base member (e.g., a glass woven cloth, a glass non-woven cloth), or a woven or non-woven cloth made of an inorganic compound other than glass; an organic fiber base member formed from organic fibers made of aromatic polyamide resin, polyamide resin, aromatic polyester resin, polyester resin, polyimide resin, fluorocarbon resin, or the like; and the like. Among these fiber base members, the glass fiber base member represented by the glass woven cloth is preferably used from a viewpoint of mechanical strength and percentage of water absorption.

Examples of glass constituting the glass fiber base member include E glass, C glass, A glass, S glass, D glass, NE glass, T glass, H glass, and the like. Among these glasses, the T glass is preferably used as the glass constituting the glass fiber base member. By using the T glass, it is possible to lower a thermal expansion coefficient of the glass fiber base member, thereby lowering the thermal expansion coefficient of the first portion 31.

The fiber base member is classified broadly into a woven cloth and a non-woven cloth. Among them, the fiber base member is preferably formed from the woven cloth, and more preferably formed from a plain woven cloth obtained by weaving warp threads and weft threads (especially, glass fiber base member). By forming the fiber base member from the plain woven cloth, if an X direction and a Y direction perpendicular to the X direction are defined on a major surface of the fiber base member, a thermal expansion coefficient of the fiber base member in each of the X and Y directions thereof is lowered. This makes it possible to lower the thermal expansion coefficient of the first portion 31 in the thickness direction of the heat transfer layer 3.

Although the glass fiber base member is preferably formed from the plain woven cloth obtained by weaving the warp threads and the weft threads, in this case, it is preferred that a weaving density of the warp threads is about the same as that of the weft threads. Specifically, a difference between the weaving density of the warp threads and the weaving density of the weft threads is preferably 20 threads/inch or less, and more preferably 15 threads/inch or less. This makes it possible to especially lower a difference between the thermal expansion coefficient of the fiber base member in the X direction thereof and the thermal expansion coefficient of the fiber base member in the Y directions thereof, thereby remarkably lowering the thermal expansion coefficient of the first portion 31 in the thickness direction of the heat transfer layer 3.

The thermal expansion coefficient of the fiber base member at a temperature of 30 to 150°C is not particularly limited to a specific value, but is preferably 10 ppm or less, and more preferably in the range of 0.1 to 5 ppm. By setting the thermal expansion coefficient of the fiber base member to a value within the above range, it is possible to lower the thermal expansion coefficient of the first portion 31.

### <Second portions>

On the other hand, as described above, each of the second portions 32 is provided so as to be inserted into each hole formed through the first portion 31 having the above described structure. Here, each of the second portions 32 has a columnar structure extending along the thickness direction of the heat transfer layer 3. Further, the plurality of second portions 32 are arranged in the tetragonal lattice manner (that is, matrix manner) in the planar view of the heat transfer layer 3.

Each second portion 32 having such a structure has a function of expanding and contracting in the thickness direction of the heat transfer layer 3 at an expansion ratio larger than that of the first portion 31 depending on the temperature changes in the object. Namely, the thermal expansion coefficient of each second portion 32 in the thickness direction of the heat transfer layer 3 is larger than that of the first portion 31 described above.

In this regard, it is preferred that the thermal expansion coefficient of each second portion 32 in the thickness direction of the heat transfer layer 3 is larger than that of the first portion 31 as described above, and the heat transfer rate of each second portion 32 is higher than that of the first portion 31. This makes it possible to change the thermal conductivity of the heat transfer sheet 1 in the thickness direction thereof at a large rate depending on the temperature changes in the object.

The thermal expansion coefficient of each second portion 32 in the thickness direction of the heat transfer layer 3 is not particularly limited to a specific value as long as it is larger than that of the first portion 31, but is preferably in the range of about 20 to 40 ppm.

A constituent material of each second portion 32 is not particularly limited to a specific one as long as it can exhibit the function as described above. As the constituent material of each second portion 32, various kinds of organic materials and various kinds of inorganic materials are used, and a metal such as A1, Cu or an A1 alloy is preferably used. In the case where each second portion 32 is formed of the metal as a major component thereof, it is possible to improve the thermal conductivity of each second portion 32.

Especially, it is preferred that the metal constituting each second portion 2 is aluminum or an alloy containing aluminum. This makes it possible to improve the thermal conductivity of each second portion 32. Further, this also makes it possible to enlarge a size of each of the gaps 33 in the thickness direction of the heat transfer layer 3, thereby improving the thermal insulation performance of the heat transfer sheet 1 by utilizing the gaps 33.

Further, it is preferred that the second portions 32 are fixed or united to the support layer 2. This makes it possible to especially improve the mechanical strength of the heat transfer sheet 1, and to efficiently transfer the heat from the support layer 2 to the second portions 32 of the heat transfer layer 3. Further, this also makes it possible to increase an amount of displacement of an end of each second portion 32 opposite from the support layer 2 due to the temperature changes in the object. For these reasons, it is possible to remarkably lower the thermal conductivity of the heat transfer sheet 1 (that is, it is possible to remarkably improve the thermal insulation performance of the heat transfer sheet 1) in the thickness direction thereof by enlarging the size of each of the gaps 33 at a low temperature.

Furthermore, an occupation ratio of an area of the second portions 32 with respect to a total area of the heat transfer layer 3 in the planar view thereof is preferably in the range of 50 to 85%, and more preferably in the range of 55 to 80%. This makes it possible to impart a required mechanical strength to the heat transfer sheet 1, and to increase an occupation ratio of the second portions 32 with respect to the whole heat transfer sheet 1.

A thickness of each second portion 32 (that is, a thickness of each second portion 32 in a direction perpendicular to a major surface of the heat transfer layer 3) is changed due to the thermal changes in the object, but is preferably set to the same as the thickness of the first portion 31 at a high temperature as described below.

### (Manufacture of heat transfer sheet)

The heat transfer sheet 1 having the above described structure can be manufactured using, for example, a first manufacture method or a second manufacture method as described below.

### - First manufacture method -

In the first manufacture method of the heat transfer sheet 1, the plurality of holes is formed through a substrate in which the above described resin composition is impregnated into the fiber base member to obtain the first portion 31, the plurality of second portions 32 are formed so that metal members each having a stick or line shape are embedded into the holes of the first portion 31, respectively, to obtain the heat transfer layer 3, and then the support layer 2 is provided by forming a metal layer onto one major surface of the heat transfer layer 3 using various kinds of film formation methods. In this way, the heat transfer sheet 1 can be manufactured.

Here, Examples of a method of impregnating the resin composition into the fiber base member include: a method of dipping the fiber base member into a resin varnish prepared by dissolving the resin composition into a solvent; a method of applying the resin varnish onto the fiber base member using various kinds of cotters; a method of spraying the resin varnish onto the fiber base member using a sprayer; and the like. Among these methods, the method of dipping the fiber base member into the resin varnish is preferably used. This makes it possible to improve impregnating ability of the resin composition with respect to the fiber base member. In this regard, it is to be noted that in the case where the fiber base member is dipped into the resin varnish, a usual impregnation application machine can be used.

In this regard, it is to be noted that the cyanate resin contained in the resin composition may be used as a prepolymer obtained by polymerizing two or more molecules of the cyanate resin. More specifically, the cyanate resin may be used singly or in combination with the prepolymer. Alternatively, two or more cyanate resins having different weight average molecular weights may be used in combination.

Such a prepolymer can be usually obtained by, for example, polymerizing three molecules of the cyanate resin (trimerizing molecules of the cyanate resin) by a heating reaction, and is preferably used to control moldability or flowability of the resin composition.

The prepolymer is not particularly limited to a specific type, but it is preferred that a prepolymer containing a trimer at an amount of 20 to 50 wt% can be used. In this regard, it is to be noted that the amount of the trimer contained in the prepolymer can be determined using, for example, an infrared spectroscopic analyzer.

Further, a solvent having an excellent solubility for the resin composition is preferably used as the solvent used for preparing the resin varnish, but a poor solvent may be used insofar as it does not adversely affect to the resin composition. Examples of the solvent having the excellent solubility for the resin composition include acetone, methyl ethyl ketone, methyl isobutyl ketone, cyclopentanone, cyclohexanone, dimethyl formamide, dimethyl acetoamide, N-methyl pyrrolidone, and the like.

An amount of a solid content contained in the resin varnish is not particularly limited to a specific value, but is preferably in the range of about 30 to 80 wt%, and more preferably in the range of about 40 to 70 wt%. This makes it possible to improve the impregnating ability of the resin varnish with respect to the fiber base member.

The resin varnish is impregnated into the fiber base member, and then dried, for example, at a temperature of 80 to 200°C. In this way, the substrate described above can be obtained.

### - Second manufacture method -

In the second manufacture method of the heat transfer sheet 1, the support layer 2 and the plurality of second portions 32 are formed together by processing a substrate made of the above metal using an etching method, and then the resin varnish as described above is embedded between the second portions 32 and cured to form the first portion 31. In this way, the heat transfer sheet 1 can be manufactured.

Hereinbelow, description will be made on a usage and working of the heat transfer sheet 1 described above with reference to FIGs. 3 to 5.

For example, as shown in FIGs. 3(a) and 3(b), the heat transfer sheet 1 is used by being provided between an obj ect 4 from which heat is to be dissipated and an dissipation member 5. Namely, the object 4 makes contact with one major surface of the heat transfer sheet 1 which is positioned at a side of the support layer 2, and the dissipation member 5 makes contact with the other surface of the heat transfer sheet 1 which is positioned at a side of the heat transfer layer 3. In this embodiment, a heat dissipation structure 10 is formed from the heat transfer sheet 1, the object 4 and the dissipation member 5.

The object 4 is not particularly limited to a specific one. Examples of the object 4 include semiconductor parts such as a transistor, a diode and an IC, electronic parts such as various kinds of heaters and a temperature sensor, batteries such as a lithium ion secondary battery and a nickel hydrogen secondary battery, and the like.

Such an object 4 can sufficiently exhibit its performance under a specific temperature range (hereinbelow, referred to as "optimal temperature") according to the kind thereof. Namely, if the temperature of the object 4 is a temperature lower than a lower limit value of the temperature range (hereinbelow, referred to as "low temperature") or it is a temperature higher than an upper limit value of the temperature range (hereinbelow, referred to as "high temperature"), there is a case that the object 4 cannot sufficiently exhibit its performance.

Temperature changes of such an object 4 occur under the influence of a heat source provided around it, an outside air temperature, generation of heat of the object 4 itself and the like.

Further, the dissipation member 5 is not particularly limited to a specific one, but an dissipation member 5 making contact with ambient air and having excellent thermal conductivity is preferably used. Examples of the dissipation member 5 include a fin-like member (radiation fin or heat dissipation fin) made of, for example, metal or carbon, a sheet-like member (radiation sheet or heat dissipation sheet) and the like.

In the case where the temperature of the object 4 is the high temperature, as shown in FIG. 3(a), the thickness of the first portion 31 becomes about the same as that of each second portion 32. As a result, the second portions 32 make contact with the dissipation member 5. This makes it possible to efficiently transfer (dissipate) the heat from the object 4 to the dissipation member 5 through the second portions 32. Namely, in the case where the temperature of the object 4 is the high temperature, the heat transfer sheet 1 can have excellent thermal conductivity in the thickness direction thereof (that is, it becomes a heat dissipation state).

On the other hand, in the case where the temperature of the object 4 is the optimal temperature or the low temperature, as shown in FIG. 3 (b), the thickness of each second portion 32 becomes smaller than that of the first portion 31. As a result, the gaps 33 are created between the second portions 32 and the dissipation member 5. This makes it possible for the gaps 33 to prevent transfer of the heat from the dissipation member 5 to the second portions 32. Namely, in the case where the temperature of the object 4 is the optimal temperature or the low temperature, the heat transfer sheet 1 can have excellent thermal insulation performance in the thickness direction thereof (that is, it becomes a heat insulation state).

In such a way, in a state that the heat transfer sheet 1 is used, in the case where the temperature of the heat transfer layer 3 is a predetermined temperature or lower, the thermal conductivity between the object 4 and the dissipation member 5 is lowered due to the creation of the gaps 33 between the second portions 32 and the dissipation member 5, whereas in the case where the temperature of the heat transfer layer 3 is a predetermined temperature or higher, the thermal conductivity between the object 4 and the dissipation member 5 is increased due to substantial elimination of the gaps 33.

This makes it possible to maintain the temperature of the object 4 within a predetermined temperature range by preventing both supercooling and overheating of the object 4 even in the case where the object 4 is used in an environment of a wide temperature range including a low temperature and a high temperature.

Especially, since the plurality of second portions 32 are arranged so as to be uniformly dispersed within the heat transfer layer 3 in the planar view thereof, it is possible to uniformize rigidity and the thermal conductivity of the heat transfer layer 1 in the thickness direction thereof all over the heat transfer layer 1 (in the planar direction of the heat transfer layer 1).

In addition, since the plurality of second portions 32 are arranged in the planer view of the heat transfer layer 3 regularly (in the tetragonal lattice manner), it is possible to impart required mechanical strength to the heat transfer sheet 1, and to increase the occupation ratio of the second portions 32 with respect to the whole heat transfer sheet 1.

Further, since each second portion 32 has the columnar shape extending along the thickness direction of the heat transfer layer 3, the second portions 32 can easily expand and contract due to the temperature changes in the object 4 without providing the spaces between the first portion 31 and the second portions 32. Especially, in the case where the gaps 33 are created, it is possible to prevent creation of gaps other than the gaps 33 between the first portion 31 and the second portions 32. This makes it possible to further improve the thermal insulation performance of the heat transfer sheet 1.

Furthermore, since the heat transfer sheet 1 is provided so that the support layer 2 is positioned on the side of the object 4, the heat transfer sheet 1 can exhibit an excellent property in each of the heat dissipation and insulation states.

Hereinbelow, description will be made on a case shown in FIGs. 4 and 5, that is, a case that the object 4 is a battery of a car 100 and the dissipation member 5 is a body or chassis of the car 100.

In the case where a temperature of the battery becomes a lower temperature and a high temperature off an optimal temperature range thereof, performance of the battery is lowered relatively remarkably. Therefore, although it is important to prevent supercooling and overheating of the battery, this prevention effect can be remarkably obtained by applying the present invention to the battery.

Especially, since there is a case that the battery put on a car is used in an environment of a wide temperature range, the prevention effect can be more remarkably obtained by applying the present invention to the battery.

Further, in the case where the dissipation member 5 is the body or chassis of the car 100, the body or chassis serves as a radiator (dissipator) through which heat received from the object 4 is dissipated. In addition, since the body or chassis of the car 100 can be effectively used as the radiator without providing such a radiator separately, it is possible to prevent the supercooling and overheating of the battery while reducing a cost thereof.

Furthermore, even if the heat transfer sheet 1 is provided between the object 4 which is a battery having a relatively heavy weight and the dissipation member 5 which supports the object 4 from a lower side thereof, since the heat transfer sheet 1 (especially, first portion 31) with the above described structure has a relatively high rigidity, it can exhibit the effects described above for a long period of time.

While the heat transfer sheet and heat dissipation structure of the present invention has been described hereinabove in respect of the illustrated embodiments, the present invention is not limited thereto.

For example, the shape of each of the first portion and the second portion in the planar view of the heat transfer layer 3 is not limited to one described in the above embodiment. For example, the first portion may include a plurality of portions arranged so as to be separated from each other in the planar view of the heat transfer layer 3, and the second portion may be provided so as to be embedded between the separated portions of the first portion.

Further, the arrangement of the separated portions of the first or second portion is not limited to one described in the above embodiment. The arrangement of the separated portions may be another regular one such as a houndstooth check manner or the like, and further may be an irregular one.

Furthermore, the shape of each separated potion of the second portion (each second portion 32 in the above embodiment) in the planar view of the heat transfer layer 3 is not limited to one described in the above embodiment. The shape of each separated potion may be an elliptical shape or a polygonal shape such as a triangle shape or a square shape, and further may be an irregular shape.

Moreover, in the above embodiment, the description has been made on the case that the cross sectional area of each separated portion of the second portion (each second portion 32 in the above embodiment) is constant along the thickness direction of the heat transfer layer 3. However, each separated portion may include a region whose cross sectional area is gradually decreased from one end to the other end along the thickness direction of the heat transfer layer 3.

### INDUSTRIAL APPLICABILITY

The heat transfer sheet of the present invention comprises the heat transfer layer having the first portion and the second portion provided in the position different from the first portion in the planar view of the heat transfer layer, the second portion being capable of expanding and contracting in the thickness direction of the heat transfer layer at the expansion ratio larger than that of the first portion depending on the temperature changes in the object, wherein in the state that the heat transfer sheet is used, in the case where the temperature of the heat transfer layer is the predetermined temperature or lower, the thermal conductivity between the object and the dissipation member is lowered due to the creation of the gap between the second portion and the dissipation member, whereas in the case where the temperature of the heat transfer layer is the predetermined temperature or higher, the thermal conductivity between the object and the dissipation member is increased due to the substantial elimination of the gap. According to such a heat transfer sheet of the present invention, it is possible to maintain the temperature of the object within the predetermined temperature range by preventing both supercooling and overheating of the object even in the case where the object is used in the environment of the wide temperature range including the low temperature and the high temperature. Thus, the heat transfer sheet of the present invention and the heat dissipation structure having this heat transfer sheet have industrial applicabilities.

## Claims

1. A heat transfer sheet (1) being adapted to be used by being provided between an object (4) from which heat is to be dissipated and a dissipation member (5) for transferring the heat between the object (4) and the dissipation member (5), comprising:
a heat transfer layer (3) having a first portion (31) and a second portion (32) provided in a position different from the first portion (31) in a planar view of the heat transfer layer (3), the second portion (32) being capable of expanding and contracting in a thickness direction of the heat transfer layer (3) at an expansion ratio larger than that of the first portion (31) depending on temperature changes in the object (4), **characterized in that**
in a state that the heat transfer sheet (1) is used, in the case where a temperature of the heat transfer layer (3) is a predetermined temperature or lower, thermal conductivity between the object (4) and the dissipation member (5) is lowered due to creation of a gap (33) between the second portion (32) and the object (4) and/or the dissipation member (5), whereas in the case where the temperature of the heat transfer layer (3) is a predetermined temperature or higher, the thermal conductivity between the object (4) and the dissipation member (5) is increased due to substantial elimination of the gap (33).

2. The heat transfer sheet as claimed in claim 1, wherein a thermal expansion coefficient of the second portion (32) in the thickness direction of the heat transfer layer (3) is larger than that of the first portion (31), and a heat transfer rate of the second portion (32) in the thickness direction of the heat transfer layer (3) is higher than that of the first portion (31).

3. The heat transfer sheet as claimed in claim 1, wherein one of the first and second portions (31, 32) has a plurality of portions arranged so as to be separated from each other in the planar view of the heat transfer layer (3), and the other portion is provided so as to be embedded between the separated plurality of portions.

4. The heat transfer sheet as claimed in claim 3, wherein the separated portions of the first or second portion (31, 32) are arranged so as to be uniformly dispersed within the heat transfer layer (3) in the planar view thereof.

5. The heat transfer sheet as claimed in claim 4, wherein the separated portions of the first or second portion (31, 32) are regularly arranged in a tetragonal lattice in the planar view of the heat transfer layer (3).

6. The heat transfer sheet as claimed in claim 3, wherein the second portion (32) has the plurality of separated portions, and the first portion (31) is provided so as to be embedded between the separated portions of the second portion (32).

7. The heat transfer sheet as claimed in claim 6, wherein each of the separated portions of the second portion (32) has a columnar structure extending along the thickness direction of the heat transfer layer (3).

8. The heat transfer sheet as claimed in claim 1 further comprising a support layer (2) that supports the heat transfer layer (3) by fixing or uniting the support layer (2) to-the second portion (32).

9. The heat transfer sheet as claimed in claim 8, wherein a constituent material of the support layer (2) is the same as that of the second portion (32).

10. The heat transfer sheet as claimed in claim 1, wherein the second portion (32) is formed of a metal as a major component thereof.

11. The heat transfer sheet as claimed in claim 10, wherein the metal constituting the second portion (32) is aluminum or an alloy containing aluminum.

12. The heat transfer sheet as claimed in claim 1, wherein an occupation ratio of an area of the second portion (32) with respect to a total area of the heat transfer layer (3) in the planar view thereof is in the range of 50 to 85%.

13. A heat dissipation structure (10), comprising:
an object (4) from which heat is to be dissipated;
a dissipation member (5); and
the heat transfer sheet (1) defined by claim 1,
wherein the heat can be dissipated from the object (4) by transferring the heat from the object (4) to the dissipation member (5) through the heat transfer sheet (1).

14. The heat dissipation structure as claimed in claim 13, wherein the heat transfer sheet (1) further comprises a support layer (2) that supports the heat transfer layer (3) by fixing or uniting the support layer (2) to the second portion (32), and the heat transfer sheet (1) is provided so that the support layer (2) is positioned on a side of the object (4).

15. Method of manufacturing a heat transfer sheet as claimed in claim 1, wherein the first portion (31) is formed by penetrating a resin composition containing a curable resin and an inorganic filler into a fiber base member.

16. Method as claimed in claim 15, wherein cyanate resin is used as the curable resin.

17. Method as claimed in claim 16, wherein glass fibers are used as fibers constituting the fiber base member.

## Patentansprüche

1. Wärmeübertragungsblech (1), das zu dessen Verwendung zwischen einem Objekt (4), von dem Wärme abgeleitet wird, und einem Ableitungselement (5) zum Übertragen der Wärme zwischen dem Objekt (4) und dem Ableitungselement (5) angeordnet ist, umfassend:
eine Wärmeübertragungsschicht (3) mit einem ersten Abschnitt (31) und einem zweiten Abschnitt (32), die in einer Position bereitgestellt werden, die unterschiedlich zu dem ersten Abschnitt (31) in einer planaren Ansicht der Wärmeübertragungsschicht (3) bereitgestellt ist, wobei der zweite Abschnitt (32) sich in eine Richtung der Dicke der Wärmeübertragungsschicht (3) mit einem Ausdehnungsverhältnis ausdehnen und zusammenziehen kann, das größer ist als das des ersten Abschnitts (31) und von Temperaturveränderungen in dem Objekt (4) abhängig ist, **dadurch gekennzeichnet, dass**
in einem Zustand, in dem das Wärmeübertragungsblech (1) verwendet wird, und in dem Fall, dass eine Temperatur der Wärmeübertragungsschicht (3) eine vorbestimmte Temperatur aufweist oder geringer ist, die thermische Leitfähigkeit zwischen dem Objekt (4) und dem Ableitungselement (5) aufgrund der Erzeugung eines Spalts (33) zwischen dem zweiten Abschnitt (32) und dem Objekt (4) und/oder dem Ableitungselement (5) verringert wird, während in dem Fall, bei dem die Temperatur der Wärmeübertragungsschicht (3) eine vorbestimmte Temperatur aufweist oder höher ist, die thermische Leitfähigkeit zwischen dem Objekt (4) und dem Ableitungselement (5) aufgrund der wesentlichen Beseitigung des Spalts (33) erhöht wird.

2. Wärmeübertragungsblech nach Anspruch 1, wobei ein Wärmeexpansionskoeffizient des zweiten Abschnitts (32) in der Richtung der Dicke der Wärmeübertragungsschicht (3) größer ist als der des ersten Abschnitts (31), und wobei eine Wärmeübertragungsgeschwindigkeit des zweiten Abschnitts (32) in die Richtung der Dicke der Wärmeübertragungsschicht (3) höher ist als die des ersten Abschnitts (31).

3. Wärmeübertragungsblech nach Anspruch 1, wobei einer der ersten und zweiten Abschnitte (31, 32) mehrere Abschnitte aufweist, die derart angeordnet sind, dass sie in planarer Ansicht der Wärmeübertragungsschicht (3) voneinander getrennt sind, wobei der andere Abschnitt derart bereitgestellt ist, dass er zwischen den mehreren getrennten Abschnitten eingebettet ist.

4. Wärmeübertragungsblech nach Anspruch 3, wobei die getrennten Abschnitte des ersten und zweiten Abschnitts (31, 32) derart angeordnet sind, dass sie gleichförmig innerhalb der Wärmeübertragungsschicht (3) in der planaren Ansicht davon verteilt sind.

5. Wärmeübertragungsblech nach Anspruch 4, wobei die getrennten Abschnitte des ersten oder zweiten Abschnitts (31, 32) gleichmäßig in einem tetragonalen Gitter in der planaren Ansicht der Wärmeübertragungsschicht (3) angeordnet sind.

6. Wärmeübertragungsblech nach Anspruch 3, wobei der zweite Abschnitt (32) die mehreren getrennten Abschnitte aufweist und der erste Abschnitt (31) derart bereitgestellt wird, dass er zwischen den getrennten Abschnitten des zweiten Abschnitts (32) eingebettet ist.

7. Wärmeübertragungsblech nach Anspruch 6, wobei jeder der getrennten Abschnitte des zweiten Abschnitts (32) eine säulenartige Struktur aufweist, die sich entlang der Richtung der Dicke der Wärmeübertragungsschicht (3) erstreckt.

8. Wärmeübertragungsblech nach Anspruch 1, ferner umfassend eine Stützschicht (2), welche die Wärmeübertragungsschicht (3) durch Befestigen oder Vereinen der Stützschicht (2) mit dem zweiten Abschnitt (32) stützt.

9. Wärmeübertragungsblech nach Anspruch 8, wobei ein Bestandteilmaterial der Stützschicht (2) das gleiche wie das des zweiten Abschnitts (32) ist.

10. Wärmeübertragungsblech nach Anspruch 1, wobei der zweite Abschnitt (32) auf einem Metall als Hauptbestandteil davon ausgebildet ist.

11. Wärmeübertragungsblech nach Anspruch 10, wobei das Metall, aus dem der zweite Abschnitt (32) besteht, Aluminium oder eine aluminiumhaltige Legierung ist.

12. Wärmeübertragungsblech nach Anspruch 1, wobei ein Auslastungsverhältnis eines Bereichs des zweiten Abschnitts (32) in Bezug auf einen Gesamtbereich der Wärmeübertragungsschicht (3) in der planaren Ansicht davon in dem Bereich von 50 bis 85 % liegt.

13. Wärmeableitungsstruktur (10), umfassend:
ein Objekt (4), von dem Wärme abgeleitet werden soll;
ein Ableitungselement (5); und das Wärmeübertragungsblech (1) nach Anspruch 1,
wobei die Wärme von dem Objekt (4) durch Übertragen der Wärme von dem Objekt (4) zu dem Ableitungselement (5) durch das Wärmeübertragungsblech (1) abgeleitet wird.

14. Wärmeableitungsstruktur nach Anspruch 13, wobei das Wärmeableitungsblech (1) ferner eine Stützschicht (2) umfasst, die die Wärmeübertragungsschicht (3) durch Übertragen oder Vereinen der Stützschicht (2) mit dem zweiten Abschnitt (32) umfasst, und das Wärmeübertragungsblech (1) derart bereitgestellt ist, dass die Stützschicht (2) auf einer Seite des Objekts (4) angeordnet ist.

15. Verfahren zum Herstellen eines Wärmeübertragungsblechs nach Anspruch 1, wobei der erste Abschnitt (31) durch Eindringen einer Harzzusammensetzung, enthaltend ein härtbares Harz und einen anorganischen Füllstoff, in ein Faserbasiselement geformt wird.

16. Verfahren nach Anspruch 15, wobei Cyanatharz als härtbares Harz verwendet wird.

17. Verfahren nach Anspruch 16, wobei Glasfasern als Fasern zum Aufbau des Faserbasiselements verwendet werden.

## Revendications

1. Feuille de transfert de chaleur (1) adaptée pour être utilisée en étant disposée entre un objet (4) dont la chaleur doit être dissipée et un organe de dissipation (5), permettant de transférer la chaleur entre l'objet (4) et l'organe de dissipation (5), comprenant :
une couche de transfert de chaleur (3) comportant une première portion (31) et une seconde portion (32) disposée en une position différente de la première portion (31) dans une vue en plan de la couche de transfert de chaleur (3), la seconde portion (32) étant capable de se dilater et se contracter dans une direction d'épaisseur de la couche de transfert de chaleur (3) avec un rapport de dilatation supérieur à celui de la première portion (31) selon des changements de température de l'objet (4), **caractérisée en ce que**
dans un état où la feuille de transfert de chaleur (1) est utilisée, dans le cas où une température de la couche de transfert de chaleur (3) est une température prédéterminée ou inférieure, la conductivité thermique entre l'objet (4) et l'organe de dissipation (5) est abaissée en raison de la création d'un écart (33) entre la seconde portion (32) et l'objet (4) et/ou l'organe de dissipation (5), tandis que dans le cas où la température de la couche de transfert de chaleur (3) est une température prédéterminée ou supérieure, la conductivité thermique entre l'objet (4) et l'organe de dissipation (5) est augmentée en raison de l'élimination sensible de l'écart (33).

2. Feuille de transfert de chaleur selon la revendication 1, dans laquelle un coefficient de dilatation thermique de la seconde portion (32) dans la direction d'épaisseur de la couche de transfert de chaleur (3) est supérieur à celui de la première portion (31), et un taux de transfert de chaleur de la seconde portion (32) dans la direction d'épaisseur de la couche de transfert de chaleur (3) est supérieur à celui de la première portion (31).

3. Feuille de transfert de chaleur selon la revendication 1, dans laquelle l'une des première et seconde portions (31, 32) comporte une pluralité de portions agencées de façon à être séparées les unes des autres dans la vue en plan de la couche de transfert de chaleur (3), et l'autre portion est disposée de façon à être encastrée entre la pluralité de portions séparées.

4. Feuille de transfert de chaleur selon la revendication 3, dans laquelle les portions séparées de la première ou la seconde portion (31, 32) sont agencées de façon à être dispersées uniformément au sein de la couche de transfert de chaleur (3) dans sa vue en plan.

5. Feuille de transfert de chaleur selon la revendication 4, dans laquelle les portions séparées de la première ou la seconde portion (31, 32) sont agencées régulièrement dans un réseau tétragonal dans la vue en plan de la couche de transfert de chaleur (3).

6. Feuille de transfert de chaleur selon la revendication 3, dans laquelle la seconde portion (32) comporte la pluralité de portions séparées, et la première portion (31) est disposée de façon à être encastrée entre les portions séparées de la seconde portion (32).

7. Feuille de transfert de chaleur selon la revendication 6, dans laquelle chacune des portions séparées de la seconde portion (32) a une structure en colonne s'étendant le long de la direction d'épaisseur de la couche de transfert de chaleur (3).

8. Feuille de transfert de chaleur selon la revendication 1, comprenant en outre une couche de support (2) qui supporte la couche de transfert de chaleur (3) en fixant ou en unissant la couche de support (2) à la seconde portion (32).

9. Feuille de transfert de chaleur selon la revendication 8, dans laquelle un matériau constitutif de la couche de support (2) est identique à celui de la seconde portion (32).

10. Feuille de transfert de chaleur selon la revendication 1, dans laquelle la seconde portion (32) est formée d'un métal en tant que son composant principal.

11. Feuille de transfert de chaleur selon la revendication 10, dans laquelle le métal constituant la seconde portion (32) est l'aluminium ou un alliage contenant de l'aluminium.

12. Feuille de transfert de chaleur selon la revendication 1, dans laquelle un rapport d'occupation d'une aire de la seconde portion (32) par rapport à une aire totale de la couche de transfert de chaleur (3) dans sa vue en plan se situe dans la plage de 50 à 85 %.

13. Structure de dissipation de chaleur (10), comprenant :
un objet (4) dont la chaleur doit être dissipée ;
un organe de dissipation (5) ; et
la feuille de transfert de chaleur (1) définie par la revendication 1,
dans laquelle la chaleur peut être dissipée de l'objet (4) en transférant la chaleur de l'objet (4) à l'organe de dissipation (5) par l'intermédiaire de la feuille de transfert de chaleur (1).

14. Structure de dissipation de chaleur selon la revendication 13, dans laquelle la feuille de transfert de chaleur (1) comprend en outre une couche de support (2) qui supporte la couche de transfert de chaleur (3) en fixant ou en unissant la couche de support (2) à la seconde portion (32), et la feuille de transfert de chaleur (1) est disposée de telle sorte que la couche de support (2) est positionnée sur un côté de l'objet (4).

15. Procédé de fabrication d'une feuille de transfert de chaleur selon la revendication 1, dans lequel la première portion (31) est formée en faisant pénétrer une composition de résine contenant une résine durcissable et une charge inorganique dans un organe à base de fibres.

16. Procédé selon la revendication 15, dans lequel une résine de cyanate est utilisée en tant que résine durcissable.

17. Procédé selon la revendication 16, dans lequel des fibres de verre sont utilisées en tant que fibres constituant l'organe à base de fibres.
